# EUROPEAN PATENT APPLICATION

(11) **EP 2 322 585 A1**
(43) Date of publication of application: **18.05.2011**
(21) Application number: 11154315.3
(22) Date of filing: 14.12.2006
(51) Int. Cl.: C09J 201/00, C09J 7/00, H01B 1/22, H01L 21/60, H05K 1/14

(54) **Adhesive composition, circuit connecting material and connecting structure of circuit member**

(30) Priority: 26.12.2005 JP 2005373042; 04.08.2006 JP 2006213230
(62) Divisional of application: 06834683.2
(71) Applicant: Hitachi Chemical Co., Ltd., Shinjuku-ku, Tokyo 163-0449 (JP)
(72) Inventor: Tatsuzawa, Takashi, Ibaraki 308-8524 (JP); Kobayashi, Kouji, Ibaraki 308-8524 (JP); Fujinawa, Tohru, Ibaraki 308-8524 (JP); Fukushima, Naoki, Ibaraki 308-8524 (JP)
(74) Representative: von Kreisler, Alek

(57) **Abstract**

An adhesive composition comprising: an adhesive component, conductive particles and insulating particles, wherein the ratio of the mean particle size of the insulating particles Ri to the mean particle size of the conductive particles Rc (Ri/Rc) is 120 to 300%, the adhesive composition comprises the insulating particles at 50 to 200 parts by volume with respect to 100 parts by volume of the conductive particles.

## Description

### ADHESIVE COMPOSITION, CIRCUIT CONNECTING MATERIAL AND CONNECTING STRUCTURE OF CIRCUIT MEMBER

### Technical Field

The present invention relates to an adhesive composition, a circuit-connecting material and a circuit member connection structure.

### Background Art

Circuit-connecting adhesive films, which form electrical connections between electrodes in the direction of pressure when mutually opposing circuits are heated and pressed, are known in the prior art. Anisotropic conductive adhesive films may be mentioned as examples of such circuit-connecting adhesive films. A typical type of known anisotropic conductive adhesive film has conductive particles dispersed in an adhesive component such as an epoxy-based adhesive or acrylic adhesive. Such anisotropic conductive adhesive films are used for electrical connection between liquid crystal display (hereinafter referred to as "LCD") panels and TCP (Tape Carrier Package) or COF (Chip On Flex) members on which are mounted, for example, semiconductors that drive the LCD_{S}.Anisotropic conductive adhesive films are also widely employed for electrical connection between TCP or COF members and printed circuit boards.

When a semiconductor is directly mounted face-down on an LCD panel or printed circuit board, the bonding has conventionally been accomplished by a wire bonding method. Recently, however, mounting of such semiconductors has been by flip-chip mounting which is advantageous for small thicknesses and narrow pitch connections. Anisotropic conductive adhesive films have been employed as circuit-connecting adhesive films for such flip-chip mounting as well (see Patent documents 1-4).

Incidentally, the trend toward more COF and finer pitch LCD modules has been intensifying in recent years. When circuit- connecting adhesive films are used, therefore, shorting between adjacent electrodes tends to occur more frequently. One means that has been considered to prevent electrical shorting is dispersion of insulating particles in the adhesive component, as described in Patent documents 5-9, for example. According to these patent documents, insulating particles with smaller particle sizes than the conductive particles are used.
[Patent document 1] Japanese Unexamined Patent Publication SHO No. 59-120436
[Patent document 2] Japanese Unexamined Patent Publication SHO No. 60-191228
[Patent document 3] Japanese Unexamined Patent Publication HET No. 1-251787
[Patent document 4] Japanese Unexamined Patent Publication HEI No. 7-90237
[Patent document 5] Japanese Unexamined Patent Publication SHO No. 51-20941
[Patent document 6] Japanese Unexamined Patent Publication HEINo. 3-29207
[Patent document 7] Japanese Unexamined Patent Publication HEI No. 4-174980
[Patent document 8] Japanese Patent No. 3048197
[Patent document 9] Japanese Patent No. 3477367

### Disclosure of the Invention

### Problems to be Solved by the Invention

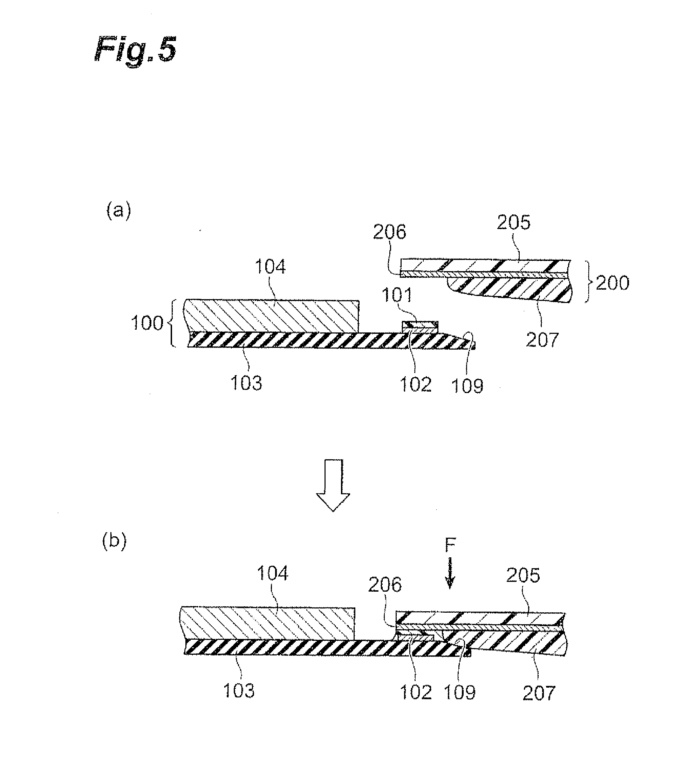

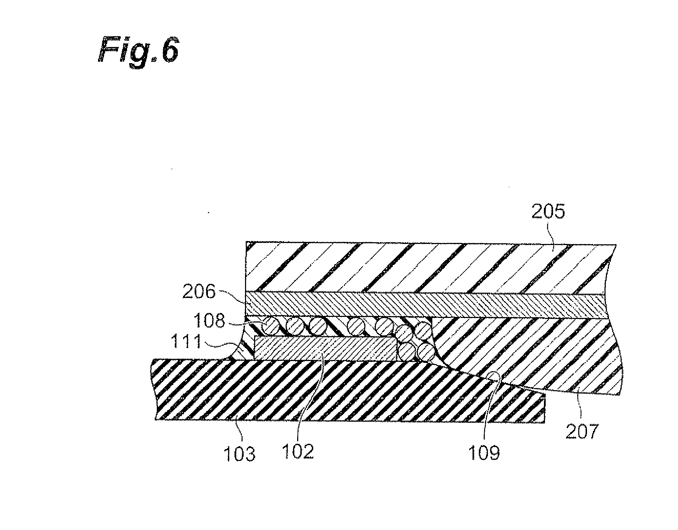

Connection between an LCD panel and COF will now be explained in detail with reference to the accompanying drawings. Fig. 5 is a cross-sectional process drawing as a schematic illustration of the connection between an LCD panel and COF, and Fig. 6 is a magnified cross-sectional schematic view of the joint after connection. The LCD panel 100 comprises an LCD panel board 103 and a liquid crystal display 104 and circuit electrode 102 formed thereover (see (Fig. 5(a)). The joint edge of the LCD panel board 103 is chamfered to provide a chamfered section 109. Separately, the COF 200 is prepared with a COF film 205 and a circuit electrode 206 and resist 207 formed thereover (see (Fig. 5(a)). A circuit-connecting adhesive film 101 containing conductive particles is foamed over the circuit electrode 102. The LCD panel 100 and COF 200 are situated with their circuit electrodes 102 and 206 facing each other, and are laminated together. Next, pressing and heating are performed in the lamination direction F so that the circuit electrodes 102 and 206 are connected via the circuit- connecting adhesive film 101, to fluidize and harden the circuit- connecting adhesive film (see Fig. 5(b)). Since the circuit-connecting adhesive film contains conductive particles, electrical connection is established between the LCD panel100 and COF by the conductive particles.

The present inventors have found that, since the chamfered section 109 of the LCD panel board 103 and resist 207 are situated adjacent to one another during connection, the conductive particles 108 that migrate as the molten circuit-connecting film fluidizes tend to aggregate and clog at the section of the hardened circuit-connecting adhesive film 111 that includes the LCD panel board 103, circuit electrode 102 and resist 207 (see Fig. 6). As a result, electrical shorting between adjacent electrodes occurs frequently, as described above.

Therefore, a circuit-connecting adhesive film is required that is suitable for COF and fine pitches, and that can prevent electrical shorting between adjacent electrodes due to aggregation of the conductive particles at the joint edge of the LCD panel. If a circuit- connecting adhesive film could be developed that allows the condition of such interelectrode shorting to be satisfactorily verified using a metallurgical microscope or the like, it would be highly useful from the viewpoint of yield and more reliable control.

It is an object of the present invention to provide an adhesive composition, a circuit-connecting material and a circuit member connection structure that are suitable for COF and fine pitches, and that sufficiently prevent aggregation of conductive particles at the joint edges of LCD panels to allow electrical shorting between adjacent electrodes to be adequately prevented and to achieve excellent connection reliability, compared to adhesive compositions in conventional circuit-connecting adhesive films.

### Means for Solving the Problems

In order to achieve the object stated above, the invention provides an adhesive composition comprising an adhesive component, conductive particles and insulating particles, wherein the ratio of the mean particle size of the insulating particles Ri to the mean particle size of the conductive particles Rc (Ri/Rc)is 120 to 300%.

In the adhesive composition of the invention, the insulating particles lie between the conductive particles. If the insulating particles have a smaller mean particle size than the conductive particles, the insulating particles will simply fill the gaps between the conductive particles after the conductive particles have aggregated. As a result, it will not be possible to effectively inhibit aggregation of the conductive particles even though the adhesive composition contains insulating particles, and shorting between adjacent electrodes will not be sufficiently prevented. In the adhesive composition of the invention, however, the mean particle size of the insulating particles Ri is 1.2 to 3 times larger than the mean particle size of the conductive particles Rc. Consequently, instead of the insulating particles filling the gaps formed between the aggregated conductive particles, the conductive particles are present in the gaps formed by the insulating particles, thus effectively inhibiting aggregation of the conductive particles. Therefore, shorting between adjacent electrodes can be satisfactorily prevented when the adhesive composition is used to connect electrodes or terminals, even with advanced COF or fine pitches.

In order to prevent shorting between adjacent electrodes when using insulating particles with a smaller mean particle size than the conductive particles, as in the prior art, means for reducing the content of conductive particles in the adhesive composition may also be considered. However, if the conductive particles are reduced in order to satisfactorily prevent electrical shorts, the electrical connection between opposing electrodes becomes insufficient and the connection reliability is reduced. In the adhesive composition of the invention, however, unlike the prior art, the mean particle size of the insulating particles Ri is 1.2 to 3 times larger than the mean particle size of the conductive particles Rc. It is therefore possible to satisfactorily prevent shorting between adjacent electrodes while adequately ensuring electrical connection between opposing electrodes.

In addition, because of the clear contrast between the insulating particles and conductive particles, it is possible to easily confirm whether or not shorting has occurred between electrodes. Moreover, since the electrical connection between opposing electrodes or terminals is ensured by the conductive particles, satisfactory superior connection reliability is obtained. It is believed that the satisfactory superior connection reliability is obtained despite the smaller mean particle size of the conductive particles Rc relative to the mean particle size of the insulating particles Ri because the insulating particles are flexible and can therefore deform (flatten) under the heating and pressing during connection, to an extent that does not impede conduction between the opposing electrodes. However, this is not necessarily the only reason.

The mean particle sizes of the conductive particles and insulating particles referred to throughout the present specification are derived and defined as follows. First, a 3000x particle image from a scanning electron microscope (SEM: trade name "S800" by Hitachi, Ltd. was used for the invention) is observed, and several particles are arbitrarily selected. In this case, 30 or more particles may be selected for accuracy, but the number of particles does not necessarily need to be a minimum of 30. Next, the selected particles are measured to determine the maximum particle size and minimum particle size. The square root of the product of the maximum particle size and minimum particle size is calculated as the particle size of each single particle. After the single particle size has been determined for all of the selected particles, their particle sizes are summed and the sum divided by the number of measured particles, defining the obtained value as the mean particle size.

The adhesive composition of the invention preferably contains 1 to 20 parts by weight of insulating particles with respect to 100 parts by weight of the adhesive component. This will allow a good balance to be achieved between the opposite effects of preventing electrical shorting between adjacent electrodes and ensuring connection reliability.

The invention further provides a circuit-connecting material that comprises the aforementioned adhesive composition and is used to bond the circuit electrode-bearing circuit members together in such a manner that the circuit electrodes of the circuit members are electrically connected. Since the circuit-connecting material comprises an adhesive composition of the invention, it can sufficiently prevent electrical shorting between adjacent electrodes and exhibit satisfactorily high connection reliability.

The circuit-connecting material of the invention is preferably in the form of a film. This is even more convenient since it will render the circuit-connecting material more manageable.

The invention still further provides a circuit member connection structure comprising: a first circuit member having a first circuit electrode formed on a main surface of a first circuit board; a second circuit member having a second circuit electrode formed on a main surface of a second circuit board; and a circuit-connecting member formed between the main surface of the first circuit board and the main surface of the second circuit board, the circuit-connecting member electrically connecting the first circuit electrode and second circuit electrode laid facing each other, wherein the circuit-connecting member is a cured product of the aforementioned circuit-connecting material. Since the circuit-connecting member in the circuit member connection structure of the invention comprises a cured circuit-connecting material according to the invention, it can sufficiently prevent electrical shorting between adjacent circuit electrodes, the effect is easily confirmed, and the connection reliability is also satisfactorily superior.

The invention still further provides a semiconductor device comprising: a semiconductor element; a board on which the semiconductor element is mounted; and a semiconductor element connecting member provided between the semiconductor element and the board, the semiconductor element connecting member electrically connecting the semiconductor element and the board, wherein the semiconductor element connecting member is a cured product of the aforementioned adhesive composition. Since the semiconductor element connecting member is a cured product of the adhesive composition of the invention, the semiconductor device can adequately prevent electrical shorting between adjacent electrodes in the semiconductor element or board, the effect can be easily confirmed, and the connection reliability between the semiconductor element and board is satisfactorily superior.

### Effect of the Invention

According to the invention it is possible to provide an adhesive composition that is suitable for COF and fine pitches, and that sufficiently prevents aggregation of conductive particles at the joint edges of LCD panels to allow electrical shorting between adjacent electrodes to be adequately prevented and to achieve excellent connection reliability, compared to the adhesive compositions used in conventional circuit-connecting adhesive films.

### Brief Description of the Drawings

Fig. 1 is a simplified cross-sectional view showing an embodiment of a circuit member connection structure according to the invention.
Fig. 2 is a process drawing in a simplified cross-sectional view showing an embodiment of a circuit member connection method according to the invention.
Fig. 3 is a simplified cross-sectional view showing an embodiment of a semiconductor device according to the invention.
Fig. 4 is a metallurgical microscope photograph showing the circuit member connection structure for an example.
Fig. 5 is a cross-sectional process drawing that schematically illustrates the connection steps for an LCD panel and COF.
Fig. 6 is a partial magnified view of (b) in Fig. 5.
Fig. 7 is a partial cross-sectional view showing the connection structure between an LCD panel and COF according to the invention.
Fig. 8 is a partial cross-sectional view showing the connection structure between an LCD panel and COF according to the prior art.

### Explanation of Symbols

1: Circuit member connection structure, 2:semiconductor device, 5: adhesive composition, 7, 108, 307: conductive particles, 8, 308: insulating particles, 10: circuit-connecting member, 11: insulating layer, 20: first circuit member, 21: first circuit board, 21 a: first circuit board main surface, 22: first circuit electrode, 30: second circuit member, 31: second circuit board, 31 a: second circuit board main surface, 32: second circuit electrode, 40: circuit-connecting material, 50: semiconductor element, 60: board, 60a: board main surface, 61: circuit pattern, 65: semiconductor element mounting board, 70: sealing material, 80: semiconductor element connecting member, 100: LCD panel, 101: circuit-connecting adhesive film, 102, 206: circuit electrode, 103: LCD panel board, 104: liquid crystal display, 109: chamfered section, 111: cured circuit-connecting adhesive film, 115: cured adhesive composition, 200: COF, 205: COF film, 207: resist.

### Best Mode for Carrying Out the Invention

Preferred embodiments of the invention will now be explained in detail, with reference to the accompanying drawings as necessary. Identical elements in the drawings will be referred to by like reference numerals and will be explained only once. The vertical and horizontal positional relationships are based on the positional relationships in the drawings, unless otherwise specified. Also, the dimensional proportions depicted in the drawings are not necessarily limitative. Throughout the present specification, the term "(meth)acrylic acid" refers to "acrylic acid" and its corresponding "methacrylic acid", "(meth)acrylate" refers to "acrylate" and its corresponding "methacrylate", "(meth)acryloxy" refers to "acryloxy" and its corresponding "methacryloxy", and "(meth)acryloyl" refers to "acryloyl" and its corresponding "methacryloyl".

The adhesive composition according to a preferred embodiment of the invention comprises an adhesive component, conductive particles and insulating particles.

The adhesive component is not particularly restricted so long as it exhibits an adhesive property, but the effect of the invention can be even more effectively exhibited by, for example, adding (a) a thermosetting resin and (b) its curing agent.

An epoxy resin is preferred as the (a) thermosetting resin. The epoxy resin may be a single epoxy compound with two or more glycidyl groups in the molecule, or it may be a combination of two or more different ones. Specifically, there may be mentioned bisphenol-type epoxy resins derived from epichlorhydrin and bisphenol A, F, AD or the like, epoxy-novolac resins derived from epichlorhydrin and phenol-novolac or cresol-novolac resins, naphthalene-based epoxy resins with a naphthalene ring-containing skeleton, or glycidylamine-type epoxy resins, biphenyl-type epoxy resins, alicyclic epoxy resins and the like. These may be used as single compounds or as combinations of two or more compounds. The epoxy resin is preferably a high purity product with the impurity ion (Na⁺, Cl‾, etc.) and hydrolyzable chlorine content reduced to below 300 ppm, in order to prevent electron migration.

The (b) curing agent for the thermosetting resin is preferably a latent curing agent from the viewpoint of obtaining a longer pot life. When the thermosetting resin is an epoxy resin, the latent curing agent may be an imidazole-based, hydrazide-based, boron trifluoride-amine chelate, sulfonium salt, amineimide, polyamine salt or dicyandiamide curing agent. From the viewpoint of extending the working life, these curing agents are preferably used in a microcapsulated form by coating with a polyurethane-based or polyester-based macromolecular substance. They may also be used alone or in combinations of two or more, and may also be used in admixture with triggers or inhibitors.

The adhesive component may contain (c) a curing agent that generates free radicals by heating or light (hereinafter referred to as "free radical generator") and (d) a radical polymerizing compound. The aforementioned effect of the invention can be even more effectively exhibited even when using such adhesive components.

As the (c) free radical generator there may be used a compound that generates active radicals by treatment involving either or both heating and light irradiation, such as a peroxide compound (organic peroxide), azo-based compound or photoinitiator.

An organic peroxide or azo-based compound generates active radicals mainly by heating. When such compounds are used as free radical generators, one or more compounds selected from among organic peroxides and/or azo-based compounds may be appropriately selected according to the connection temperature, connecting time and desired pot life.

From the standpoint of achieving both high reactivity and a long pot life, the organic peroxide when used preferably has a 10 hour half- life temperature of 40°C or higher and a 1 minute half-life temperature of no higher than 180°C, and more preferably it has a 10 hour half-life temperature of 60°C or higher and a 1 minute half-life temperature of no higher than 170°C. In order for the organic peroxide to prevent corrosion of the circuit electrodes (terminals) of the circuit member, the chloride ion or organic acid content is preferably no greater than 5000 ppm, and more preferably a low amount of organic acid is generated after thermolysis.

The (c) free radical generator is preferably added at 0.05 to 10 wt% and more preferably 0.1.to 5 wt% based on the total weight of the adhesive component.

More specifically, one or more selected from the group consisting of diacyl peroxides, dialkyl peroxides, peroxy dicarbonates, peroxyesters, peroxyketals, hydroperoxides and silyl peroxides may be suitably used as organic peroxides. Of these, one or more selected from the group consisting of peroxyesters, dialkyl peroxides and hydroperoxides are especially preferred in order to further control corrosion of the terminals in the circuit member connection structure or semiconductor device. Peroxyesters are even more preferred from the viewpoint of obtaining higher reactivity.

As examples of diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide. These may be used as single compounds or as combinations of two or more compounds.

As examples of dialkyl peroxides there may be mentioned a,a'-bis(t-butylperoxy)diisopropylbenzene, dicumyl peroxide, 2,5-dimethyl-2,5-bis(t-butylperoxy)hexane and t-butylcumyl peroxide.

As examples of peroxy dicarbonates there may be mentioned di-n-propylperoxy dicarbonate, diisopropylperoxy dicarbonate, bis(4-t-butylcyclohexyl)peroxy dicarbonate, di-2-ethoxymethoxyperoxy dicarbonate, bis(2-ethylhexylperoxy) dicarbonate, dimethoxybutylperoxy dicarbonate and b is (3-methyl-3-methoxybutylperoxy)dicarbonate. These may also be used as single compounds or as combinations of two or more compounds.

As examples of peroxy esters there may be mentioned cumylperoxy neodecanoate, 1,1,3,3-tetramethylbutylperoxy neodecanoate, 1-cyclohexyl-l-methylethylperoxy neodecanoate, t-hexylperoxy neodecanoate, t-butylperoxy pivalate, 1,1,3,3-tetramethylbutylperoxy 2-ethylhexanoate, 2,5-dimethyl-2,5-bis(2-ethylhexanoylperoxy)hexane, 1-cyclohexyl-1-methylethylperoxy 2-ethyl hexanoate, t-hexylperoxy 2-ethyl hexanonate, t-butylperoxy 2-ethylhexanoate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethy1-2,5-bis(m-toluoylperoxy)hexane, t-butyl peroxyisopropyl monocarbonate, t-butylperoxy-2-ethylhexyl monocarbonate, t-hexylperoxybenzoate, t-butylperoxy acetate and bis(t-butylperoxy)hexahydroterephthalate. These may be used as single compounds or as combinations of two or more compounds.

As examples of peroxy ketals there may be mentioned 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyclododecane and 2,2-bis(t-butylperoxy)decane. These may be used as single compounds or as combinations of two or more compounds.

As examples of hydroperoxides there may be mentioned diisopropylbenzene hydroperoxide and cumene hydroperoxide. These may be used as single compounds or as combinations of two or more compounds.

As examples of silyl peroxides there may be mentioned t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide. These may be used as single compounds or as combinations of two or more compounds.

The aforementioned organic peroxides and azo-based compounds may be used alone or in mixtures of two or more. They may also be used in combination with triggers, inhibitors and the like. From the viewpoint of extending the working life, these compounds are preferably used in a microcapsulated form by coating with a polyurethane-based or polyester-based macromolecular compound.

As examples of photoinitiators there may be mentioned benzoin ethers such as benzoin ethyl ether and isopropyl benzoin ether, benzylketals such as benzyl and hydroxycyclohexylphenylketone, ketones such as benzophenone and acetophenone and derivatives thereof, thioxanthones or bisimidazoles.

When a photoinitiator is used, a suitable photoinitiator may be selected depending on the wavelength of the light source used and the desired curing property. The photoinitiator may, if necessary, be used in combination with sensitizing agents such as amines, sulfur compounds, phosphorus compounds, and the like, in any desired proportions.

As sensitizing agents there are preferred aliphatic amines, aromatic amines, cyclic amines such as piperidines which have nitrogen-containing cyclic structures, o-tolylthiourea, sodium diethyl dithiophosphate, soluble salts of aromatic sulfinic acids, N,N'-dimethyl-p-aminabenzonitrile, N,N'-diethyl-p-aminobenzonitrile, N,N'-di((3- cyanoethyl)-p-aminobenzonitrile, N,N'-di(β-chloroethyl)-p-aminobenzonitrile, tri-n-butylphosphine and the like.

Alternatively, there may be used non-pigment-type sensitizing agents such as propiophenone, acetophenone, xanthone, 4-methylacetophenone, benzophenone, fluorene, triphenylene, biphenyl, thioxanthone, anthraquinone, 4,4'-bis(dimethylamino)benzophenone, 4,4'-bis(diethylamino)benzophenone, phenanthrene, naphthalene, 4-phenylacetophenone, 4-phenylbenzophenone, 1-iodonaphthalene, 2-iodonaphthalene, acenaphthene, 2-naphthonitrile, 1-naphthonitrile, chrysene, benzyl, fluoranthene, pyrene, 1,2-benzoanthracene, acridine, anthracene, perylene, tetracene and 2-methoxynaphthalene, and pigment-type sensitizing agents such as thionine, methylene blue, lumiflavin, riboflavin, lumichrome, coumarin, psoralen, 8-methoxypsoralen, 6-methylcoumarin, 5-methoxypsoraien, 5-hydroxypsoralen, coumarylpyrone, acridine orange, acriflavin, proflavin, fluorescein, eosin Y, eosin B, erythrosine, rose Bengal and the like.

The (c) free radical generator may also be a combination of the aforementioned photoinitiators with compounds that generate radicals primarily by heating, such as organic oxides or azo-based compounds.

The (d) radical polymerizing compound has a functional group that polymerizes by active radicals, and for example, (meth)acrylic acid ester compounds and maleimide compounds may be suitably used. The radical polymerizing compound may be a polymerizable monomer or a polymerizable oligomer. Since the polymerizable oligomer will generally have high viscosity, when a polymerizable oligomer is used the viscosity is preferably adjusted by the use of a polymerizable monomer such as a low-viscosity polymerizable polyfunctional (meth)acrylate monomer.

As (meth)acrylic acid ester compounds there may be used polymerizable oligomers such as epoxy (meth)acrylate oligomers, urethane (meth)acrylate oligomers, polyether (meth)acrylate oligomers, polyester (meth)acrylate oligomers and the like, or polymerizable monomers such as (meth)acrylates. These may be used as single compounds or as combinations of two or more compounds.

As specific examples of (meth)acrylic acid ester compounds there may be mentioned urethane (meth)acrylate, methyl (meth)acrylate, ethyl (meth)acrylate, isopropyl (meth)acrylate, isobutyl (meth)acrylate, ethyleneglycol di(meth)acrylate, diethyleneglycol di(meth)acrylate, triethyleneglycol di(meth)acrylate, trimethylolpropane tri(meth)acrylate, tetramethylolmethane tetra (meth)acrylate, 2-hydroxy-1,3-di(meth)acryloxypropane, 2,2-bis[4-((meth)acryloxymethoxy)phenyl] propane, 2,2-bis[4-((meth)acryloxypolyethoxy)phenyl] propane, dicyclopentenyl (meth)acrylate, tricyclodecanyl (meth)acrylate, dimethyloltricyclorlecane di(meth)acrylate, bis((meth)acryloxyethyl) isocyanurate, ε-caprolactone-modifiied tris((meth)acryloxyethyl) isocyanurate and tris((meth)acryloxyethyl) isocyanurate. These may be used as single compounds or as combinations of two or more compounds.

Among those mentioned above, urethane (meth)acrylate is preferred from the viewpoint of superior adhesion. In addition to these, the adhesive component for this embodiment most preferably contains an added radical polymerizing compound that exhibits a Tg of above 100°C alone, after being crosslinked with the aforementioned organic peroxide which is used to improve the heat resistance. As examples of such radical polymerizing compounds there may be mentioned compounds with dicyclopentenyl groups, compounds with tricyclodecanyl groups and/or compounds with triazine rings. Particularly preferred for use among these are radical polymerizing compounds with tricyclodecanyl and/or triazine ring groups.

As (meth)acrylic acid ester compounds there are preferably used phosphoric acid ester compounds with (meth)acrylate groups, also for the purpose of improving the adhesive strength on inorganic material surfaces such as metals. As examples of phosphoric acid ester compounds there may be mentioned products obtained by reacting phosphoric anhydride and 2-hydroxyl (meth)acrylate by ordinary methods.

More specifically, preferred phosphoric acid ester compounds are compounds represented by the following general formula (1). In formula (1), n represents an integer of 1to 3 and R represents hydrogen or a methyl group. As a specific examples of compounds represented by formula (1) there may be mentioned mono(2-(meth)acryloyloxyethyl) acid phosphate and di(2-(meth)acryloyloxyethyl)acid phosphate. The phosphoric acid ester compound is synthesized, for example, by reacting phosphoric anhydride and 2-hydroxylethyl (meth)acrylate.

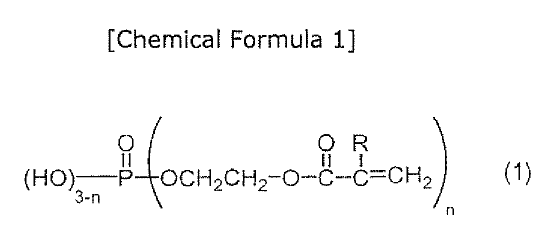

Such a phosphoric acid ester compound is added at 0.1 to 10 parts by 15 weight and more preferably 0.5 to 5 parts by weight with respect to 100 parts by weight of the total adhesive component.

Preferred maleimide compounds are those with at least two maleimide groups in the molecule.As examples of maleimide compounds with two or more maleimide groups in the molecule there may be mentioned 1-methyl-2,4-bismaleimidebenzene, N,N'-m-phenylenebismaleimide, N,N'-p-phenylenebismaleimide, N,N'-m-toluylenebismaleimide, N,N'-4,4-biphenylenebisma lei mide, N, N'-4,4- (3,3'-di methylbiphenylene)bisma lei mide, N,N-4,4-(3,3`-dimethy(diphenylmethane) bismaleimide, N,N'-4,4-(3,3'-diethyl diphenylmethane) bismaleimide, N_{,}N'-4,4-diphenyfmethane bismaleimide, N,N'-4,4-diphenylpropane bismaleimide, N,N'-4,4-diphenyl ether bismaleimide, N,N'-3,3'-diphenylsulfone bismaleimide, 2,2-bis **[4-(4-**maleimidephenoxy)phenyl]propane, 2,2-bis [3 -s-butyl-4,8-(4-maleimidephenoxy)phenyl]propane, 1,1- bis [4-(4-maleimidephenoxy)phenyl]decane,4,4`-cyclohexylidene-bis⁅1-(4-maleimidephenoxy)-2-cyclohexyl] benzene, 2,2-bis [4-(4-maleimidephenoxy)phenyl]hexafluoropropane and the like. These may be used as single compounds or as combinations of two or more compounds. Alternatively, they may be used in combination with allyl compounds such as allylphenol, allylphenyl ether or allyl benzoate.

If necessary, an appropriate amount of a polymerization inhibitor such as hydroquinone or methyl ether hydroquinone may be added to the adhesive component.

For this embodiment, the radical polymerizing compound used may be a single compound or a combination of two or more compounds. Among these radical polymerizing compounds, the adhesive component of this embodiment is preferably one containing a radical polymerizing compound with a 25°C viscosity of 100,000 to 1,000,000 mPa•s and more preferably containing a radical polymerizing compound with a 25°C viscosity of 100,000 to 500,000 mPa•s, from the viewpoint of enhancing the connecting processability. The viscosity of the radical polymerizing compound may be measured using a commercially available Brookfield viscometer.

The adhesive component of this embodiment may also be used after its shaping into a film. In this case, the adhesive component may contain a film-forming polymer. As examples of film-forming polymers there may be mentioned polystyrene resins, polyethylene resins, polyvinyl butyral resins, polyvinyl formal resins, polyimide resins, polyamide resins, polyvinyl chloride resins, polyphenylene oxide resins, urea resins, melamine resins, phenol resins, xylene resins, polyisocyanate resins, phenoxy resins, polyimide resins, polyester- urethane resins and polyester resins other than those mentioned above. These may be used as single compounds or as combinations of two or more compounds.

Among those mentioned above, resins with functional groups such as hydroxyl are preferred in order to enhance the adhesive property. Such polymers that have been modified with radical-polymerizing functional groups may also be used for the film-forming polymer. The weight-average molecular weight of such a polymer is preferably at least 10,000. The weight-average molecular weight is also preferably less than 1,000,000 for more satisfactory miscibility with the other additives in the adhesive component.

The weight-average molecular weight referred to throughout the present specification is the value measured by gel permeation chromatography (GPC) under the following conditions, with calculation based on a standard polystyrene calibration curve.

### (GPC conditions)

Device: Hitachi L-6000 (trade name of Hitachi, Ltd.)
Detector: L-3300 RI (trade name of Hitachi, Ltd.).
Column: GL-R420 Gel pack + GL-R430 Gel pack + GL-R440 Gel pack
(total: 3) (trade name of Hitachi Chemical Co., Ltd.)
Eluent: tetrahydrofuran
Measuring temperature: 40°C.
Flow rate: 1.75 ml/min

The adhesive composition of this embodiment can be imparted with conductivity by addition of conductive particles. This will allow the adhesive composition of this embodiment to be used as a conductive adhesive, such as a circuit-connecting material, in fields such as electrical and electronic industries for circuit electrodes, semiconductors and the like.

The conductive particles are not particularly restricted so long as they have conductivity that permits electrical connection to be established. As examples of such conductive particles there may be mentioned metallic particles such as Au, Ag, Ni, Cu or solder, or carbon particles. The conductive particles may consist of nucleus particles cover with one or more layers, with a conductive outermost layer covering them. In this case, the outermost layer is preferably composed mainly of a precious metal such as Au, Ag and/or a platinum family metal rather than a transition metal such as Ni or Cu, and more preferably one or more such precious metals, from the viewpoint of obtaining a superior pot life. Au is most preferred among these precious metals.

The conductive particles may also be further covered with a layer composed mainly of a precious metal, over the surfaces of the particles consisting mainly of a transition metal in the nuclei or over the layer composed mainly of a transition metal covering the nuclei. The conductive particles may comprise insulating particles composed mainly of non-conductive glass, ceramic, plastic or the like as nuclei, and a layer composed mainly of the aforementioned metal or carbon covering the surfaces of the nuclei.

When the conductive particles comprise insulating particle nuclei covered with a conductive layer, preferably the insulating particles are composed mainly of plastic and the outermost layer is composed mainly of a precious metal. This will allow the conductive particles to satisfactorily deform under heat and pressure when the adhesive composition is used as an electrical connection material, such as a circuit-connecting material. Furthermore, the contact area of the conductive particles with the electrodes and terminals will be increased upon connection of the circuit. From the same viewpoint of improving the connection reliability of the electrical connection material, the conductive particles are preferably particles containing a metal that melts under the aforementioned heating, as the major component.

When the conductive particles comprise insulating particles as the nuclei covered with a conductive layer, the thickness of the conductive layer is preferably at least 100 angstrom (10 nm) in order to obtain even more satisfactory conductivity. Also, when the adhesive component is a radical polymerizing system and the conductive particles have a construction wherein a layer composed mainly of a precious metal covers the surfaces of the particles composed mainly of a transition metal as the nuclei, or the surface of a layer composed mainly of the transition metal covering the nuclei, the thickness of the layer composed mainly of the precious metal as the outermost layer is preferably at least 300 angstrom (30 nm). A thickness of less than 300 angstrom will result in a more rupturable outermost layer. As a result, the exposed transition metal will come into contact with the adhesive component and more easily generate free radicals by the oxidation- reduction activity of the transition metal, thus tending to reduce the pot life.

When used for connection between circuits, the mean particle size of the conductive particles Rc is preferably 1 to 20 Km, more preferably 1.5 to 15 Km and even more preferably 2 to 10 Km, since shorting between adjacent electrodes is reduced if it is lower than the circuit electrode height. The conductive particles may be appropriately selected from among particles with a 10% compression modulus (K value) of 100 to 1000 kgf/mm².

The mixing proportion of the conductive particles is not particularly restricted, but is preferably 0.1 to 30 parts by volume and more preferably 0.1 to 10 parts by volume with respect to 100 parts by volume of the adhesive component. If the value is less than 0.1 part by volume it will tend to be difficult to achieve satisfactory conductivity, while if it exceeds 30 parts by volume there will be a greater risk of shorting between circuits. The mixing proportion of the conductive particles (by volume) is determined based on the volume of each component before curing of the adhesive composition at 23°C. The volume of each component may be measured by a method of calculating the volume from the weight based on the specific gravity, or a method of loading the component into a vessel such as a graduated cylinder containing an appropriate solvent (water, alcohol or the like) that thoroughly wets the component without dissolving or swelling it, and calculating based on the increased volume.

The insulating particles are not particularly restricted so long as they can block electrical conduction between conductive particles when in contact with the conductive particles. Preferred as insulating particles are particles composed mainly of an insulating resin. As examples of insulating resins there may be mentioned (meth)acrylic acid ester copolymers such as polyethylene resin, polystyrene resin, polyamide resin, polyurethane resin, (meth)acrylic resin, styrene(meth)acrylic acid ester copolymer and ethylene-(meth)acrylic acid ester copolymer, (meth)acrylic acid copolymers such as ethylene(meth)acrylic acid copolymer, styrenedivinylbenzene copolymers, styrene-butadiene copolymers, divinylbenzene resins, styrene-isobutylene copolymers, ethylene-propylene copolymers, styrene-ethylenebutylene copolymers, phenoxy resins, solid epoxy resins and silicone resins. Silicone resins are preferred among those mentioned above from the viewpoint of achieving superior flexibility. They may be used as single compounds or as combinations of two or more compounds.

The insulating particles may be particles made of an insulating material composed mainly of an insulating resin as mentioned above, or they may be particles with insulating or conductive nuclei covered with one or more insulating layers or conductive layers and having an outermost layer with an insulating property.

The ratio of the mean particle size of the insulating particles Ri to the mean particle size of the conductive particles Rc (Ri/Rc) is 120 to 300%, or a size factor of 1.20 to 3.00. An Ri/Rc ratio of at least 120% will more effectively and reliably prevent aggregation of the conductive particles than if it is less than 120%. This tendency becomes more pronounced with a smaller mixing proportion of insulating particles. This will now be explained in detail with reference to the accompanying drawings.

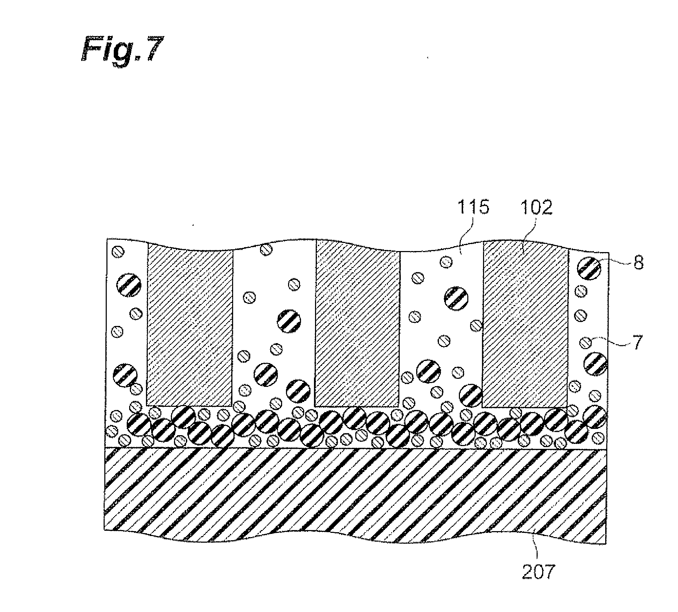

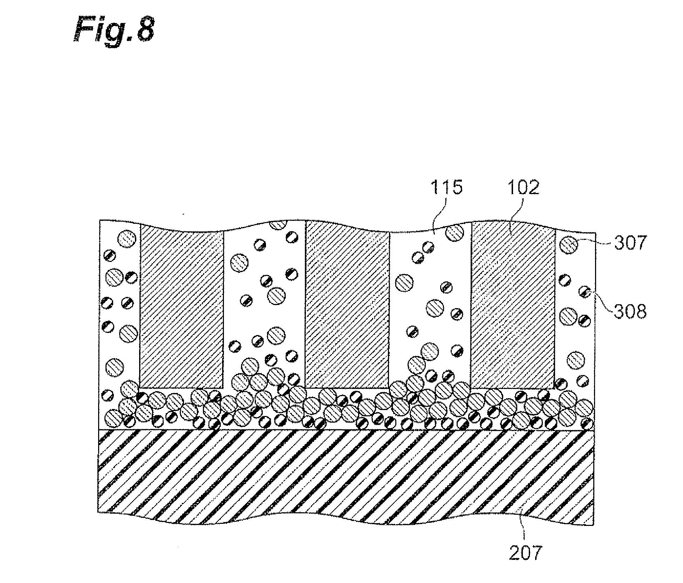

Fig. 7 is a partial cross-sectional view schematically showing the state of aggregation of conductive particles and insulating particles in a connection structure between an LCD panel and COF according to the invention, i.e. with an Ri/Rc ratio of 120 to 300%. Fig. 8 is a partial cross-sectional view schematically showing the state of aggregation of conductive particles and insulating particles in a connection structure between an LCD panel and COF, where the mean particle size of the insulating particles Ri is lower than the mean particle size of the conductive particles Rc.

In Fig. 7, the cured adhesive composition 115 is filled in the pitch between circuit electrodes 102 formed in the LCD panel and between the terminals of the circuit electrodes 102 and the resist 207 of the COF. The cured adhesive composition 111 contains conductive particles 7 and insulating particles 8. Most of the particles are aggregated between the terminals of the circuit electrodes 102 and the resist 207. At the section where most of the particles are aggregated, the particles with larger sizes become contiguous and the particles with smaller sizes tend to fill the gaps between those larger particles, thus allowing more of the particles to be housed in a prescribed space volume. In other words, if the particle sizes of the insulating particles 8 are larger than the particle sizes of the conductive particles 7 as shown in Fig. 7, the insulating particles 8 become contiguous and the conductive particles 7 come to fill the gaps between the insulating particles 8. It is conjectured that shorting between adjacent circuit electrodes 102 can be adequately reduced according to the invention because it allows mutual contact between the conductive particles 7 to be prevented.

However, if the particle sizes of the insulating particles 308 are smaller than the particle sizes of the conductive particles 307 as shown in Fig. 8, the conductive particles 307 become contiguous and the insulating particles 308 will come to fill the gaps between the conductive particles 307. As a result, it is difficult for the insulating particles 308 to adequately prevent shorting between the adjacent circuit electrodes 102 by the conductive particles 307.

Also, an Ri/Rc ratio of no greater than 300% will provide more satisfactory connection between the electrodes and terminals by the conductive particles than a higher ratio. The adhesive composition of this embodiment may therefore be used to satisfactorily prevent electrical shorting during connection between opposing electrodes or terminals, even with narrow pitches between the adjacent electrodes or terminals. In addition, because of the clear contrast between the insulating particles and conductive particles, it is possible to easily confirm whether or not shorting has occurred between electrodes or terminals. Moreover, since electrical connection between opposing electrodes or terminals is ensured by the conductive particles, satisfactory superior connection reliability is obtained. For the same reason, the mean particle size of the insulating particles Ri is preferably 130 to 200% of the mean particle size of the conductive particles Rc. Also, the mean particle size of the insulating particles Ri may be, for example, T..2 to 2fl pm.

If the Ri/Rc ratio is less than 120%, a larger insulating particle 5 content will lower the flow property of the adhesive composition, thus impairing the circuit connectability.

The insulating particles preferably have a 10% compression modulus (K value) of no greater than the K value of the conductive particles. This will improve the flexibility of the insulating particles, and more effectively prevent the insulating particles from blocking conduction between the opposing electrodes or terminals by the conductive particles. For example, the insulating particles may have a 10% compression modulus (K value) of 1 to 1000 kgf/mm². However, since conduction by the conductive particles can also be ensured by adjusting the conductive particle material, the insulating particle material and the heat and pressure conditions during the main contact bonding, the K value of the insulating particles is not necessarily limited to the aforementioned range.

The mixing proportion of the insulating particles is not particularly restricted, but is preferably 0.1 to 20 parts by weight and more preferably 5 to 10 parts by weight with respect to 100 parts by weight of the adhesive component, from the viewpoint of achieving a satisfactory balance between preventing electrical shorting and improving the electrical connection properties. If the value is less than 0.1 part by weight, shorting will occur more easily between the adjacent electrodes or terminals due to the conductive particles, and if it is greater than 20 parts by weight, the connectability between the opposing circuits or terminals will tend to be reduced.

From the viewpoint of even more effectively exhibiting the aforementioned effect of the invention, the mixing proportion of the insulating particles is preferably 50 to 300 parts by volume and more preferably 100 to 200 parts by volume with respect to 100 parts by volume of the conductive particles.

The adhesive composition of this embodiment may also contain other added materials as suited for the purpose of use, in addition to those mentioned above. For example, coupling agents and adhesion aids such as adhesiveness improvers and leveling agents may be added to the adhesive composition as appropriate. Such additives can result in more satisfactory adhesion and handleability. The adhesive composition of this embodiment may further contain rubber. Addition of rubber can help to relax stress and improve the adhesive property. A stabilizer may also be added to the adhesive composition in order to control the curing speed and impart storage stability. The adhesive composition of this embodiment may still further contain added fillers, softening agents, accelerators, age inhibitors, coloring agents, flame retardants, thixotropic agents, phenol resins, melamine resins, isocyanates and the like.

The adhesive composition of this embodiment may be used in paste form if it is a liquid at ordinary temperature (25°C). When it is a solid at ordinary temperature, it may be heated into a paste, or dissolved in a solvent to form a paste. The solvent used is not particularly restricted so long as it does not react with the adhesive composition and exhibits sufficient solubility, but it is preferably one with a boiling point of 50 to 150°C at ordinary pressure. If the boiling point is below 50°C, the solvent will evaporate when left out at room temperature (25°C), thus limiting it use in open systems. If the boiling point is above 150°C, it will be difficult to evaporate off the solvent and the reliability after adhesion will thus tend to be adversely affected.

The adhesive composition of this embodiment may also be used after its shaping into a film, as mentioned above. The adhesive film may be obtained by coating a mixture of the adhesive composition and a solvent, if necessary, onto a releasable base such as a fluorine resin film, a polyethylene terephthalate film or a release sheet, or impregnating a nonwoven fabric or the like with the mixture and placing it on a releasable base, and then removing the solvent by heating. Forming the adhesive composition into a film in this manner provides the additional advantage of excellent handleability.

When the adhesive film is to be used as a circuit-connecting material, the circuit-connecting material forms an electrical connection between facing circuit electrodes as it melts and flows upon heating and pressing while sandwiched between the pair of opposing circuit members. It is then cured to exhibit its adhesive strength. The flow property of the circuit-connecting material is therefore an important property. Specifically, the value of the flow property index (B)/(A) is preferably 1.3 to 3.0 and more preferably 1.5 to 2.5. The value of the flow property index (B)/(A) represents the relationship between the initial area (A) of the circuit-connecting material and the area (B) after heating and pressing, when the circuit-connecting material film (thickness: 35 pm, 5 mm x 5 mm) is sandwiched between two glass plates (thickness: 0.7 mm, 15 mm x 15 mm) and heated and pressed at 170°C, 2 MPa for 10 seconds. If the value of (B)/(A) is less than 1.3 the flow property will be insufficient to establish satisfactory connection, while if it is greater than 3.0, air bubbles will tend to be generated and will lower the reliability.

The adhesive film will normally consist of a single layer, but the adhesive film of this embodiment may instead be used in the form of a film with multiple layers with different compositions. The adhesive film is preferably a multilayer film having, for example, a separate layer containing a free radical generator and a layer containing the conductive particles. Alternatively, the adhesive film may be a multilayer film having a separate layer containing a thermosetting resin and a layer containing a curing agent. These modes can prevent shorting between adjacent electrodes with very fine pitches and extend the working life. The insulating particles may be present in each layer, or they may be present in only one of the layers. However, from the viewpoint of more effectively preventing electrical shorting by the conductive particles, the insulating particles are preferably used in the layer containing the conductive particles.

The adhesive composition of this embodiment may also be bonded to an adherend with a combination of heating and pressurization. The heating temperature is not particularly restricted but is preferably a temperature of 100 to 250°C. The pressure is not particularly restricted so long as it is in a range that does not damage the adherend, and for most purposes it is preferably 0.1 to 10 MPa. The heating and pressurization are preferably carried out for a period in a range of 0.5 to 120 seconds. For example, the adhesive composition and adherend may be bonded by heating and pressing for 2 to 5 seconds under conditions with a temperature of 140 to 200°C and a pressure of 1 to 3 MPa.

The adhesive composition of this embodiment may be used as a circuit-connecting material connecting different types of adherends, for example, circuit members including chip parts such as semiconductor chips, resistor chips and condenser chips, or printed boards. Specifically, it may be used as a circuit-connecting material such as described above and also below, typically an anisotropic conductive adhesive, or as a semiconductor element adhesive material such as CSP elastomer, CSP underfill material, LOC tape or the like.

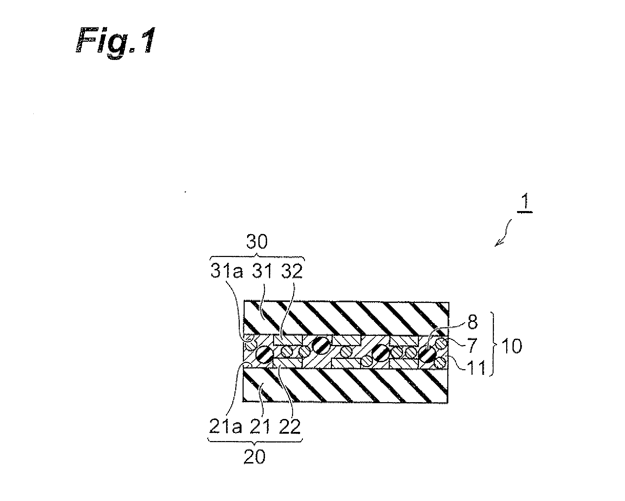

Fig. 1 is a simplified cross-sectional view showing an embodiment of a circuit member connection structure according to the invention. The connection structure 1 shown in Fig. 1 comprises a first circuit member 20 and a second circuit member 30 which are mutually opposing, and a circuit-connecting member 10 which is formed between the first circuit member 20 and second circuit member 30 and connects them.

The first circuit member 20 comprises a first circuit board 21 and first circuit electrodes 22 formed on the main surface 21 a of the first circuit board 21. The second circuit member 30 comprises a second circuit board 31 and second circuit electrodes 32 formed on the main surface 31 a of the second circuit board 31. An insulating layer (not shown) may also be formed on the main surface 21 a of the first circuit board 21 and on the main surface 31 a of the second circuit board 31.

The first and second circuit boards 21, 31 may be boards made of inorganic materials such as semiconductor, glass or ceramic materials, organic materials such as polyimide base materials including TCP, FPC and COF or polycarbonates, polyestersulfiones and the like, and materials that are composites of such inorganic or organic materials.

As specific examples for the first and second circuit members 20, 30 there may be mentioned glass or plastic boards, printed circuit boards, ceramic circuit boards, flexible circuit boards, semiconductor silicon chips and the like on which circuit electrodes made of ITO or the like are formed for use in liquid crystal display devices. These may be used in combinations if necessary.

The circuit-connecting member 10 is formed from a cured circuit-connecting material comprising the aforementioned adhesive composition containing the conductive particles and insulating particles. The circuit-connecting member 10 comprises an insulating layer 11 and conductive particles 7 and insulating particles 8 dispersed in the insulating layer 11. The conductive particles 7 in the circuit-connecting member 10 are situated not only between the opposing first circuit electrodes 22 and second circuit electrodes 32, but also between the main surfaces 21 a and 31 a. The insulating particles 8 are situated between the main surface 21a and main surface 31a. The 40°C storage elastic modulus of the circuit-connecting member 10 is preferably 100 to 3000 MPa and more preferably 500 to 2000 MPa.

In the connection structure 1, the conductive particles 7 are in direct contact with both the first and second circuit electrodes 22, 32. The first and second circuit electrodes 22, 32 are therefore electrically connected via the conductive particles 7. Thus, connection resistance between the first circuit electrodes 22 and the second circuit electrodes 32 is sufficiently reduced. Consequently, smooth current flow can be achieved between the first and second circuit electrodes 22, 32, to allow the function of the circuit to be adequately exhibited. Sections may also be present where the first circuit electrodes 22 and second circuit electrodes 32 are in direct contact and are electrically connected.

The insulating particles 8 lying between the adjacent first circuit electrodes 22 and the adjacent second circuit electrodes 32 effectively inhibit aggregation of the conductive particles 7. This satisfactorily prevents shorting between adjacent circuit electrodes by the conductive particles 7. This effect is due to the fact that the mean particle size of the insulating particles 8 (Ri) is 1.2 to 3 times larger than the mean particle size of the conductive particles 7 (Rc). That is, when the insulating particles 8 and conductive particles 7 have such a relationship, the insulating particles 8 are not present in the gaps formed by the aggregated conductive particles 7 between the main surfaces 21 a, 31 a, but rather the conductive particles 7 are present in the gaps formed by the aggregated insulating particles 8. This sufficiently inhibits aggregation of the conductive particles 7. As a result, the circuit- connecting member 10 effectively functions as an anisotropic conductive film, and satisfactorily high connection reliability is exhibited.

Moreover, when the connection structure 1 is an LCD panel board/COF connection structure, the aggregation of the conductive particles 7 between the chamfered section of the LCD panel board (not shown) and the solder resist section of the COF (not shown) is also adequately prevented. Shorting between adjacent circuit electrodes by the conductive particles 7 is thus satisfactorily prevented from this viewpoint as well.

In addition, because of the clear contrast between the conductive particles 7 and insulating particles 8 in the connection structure 1, it is possible to easily confirm whether or not shorting has occurred between the adjacent circuit electrodes 22 and 32.

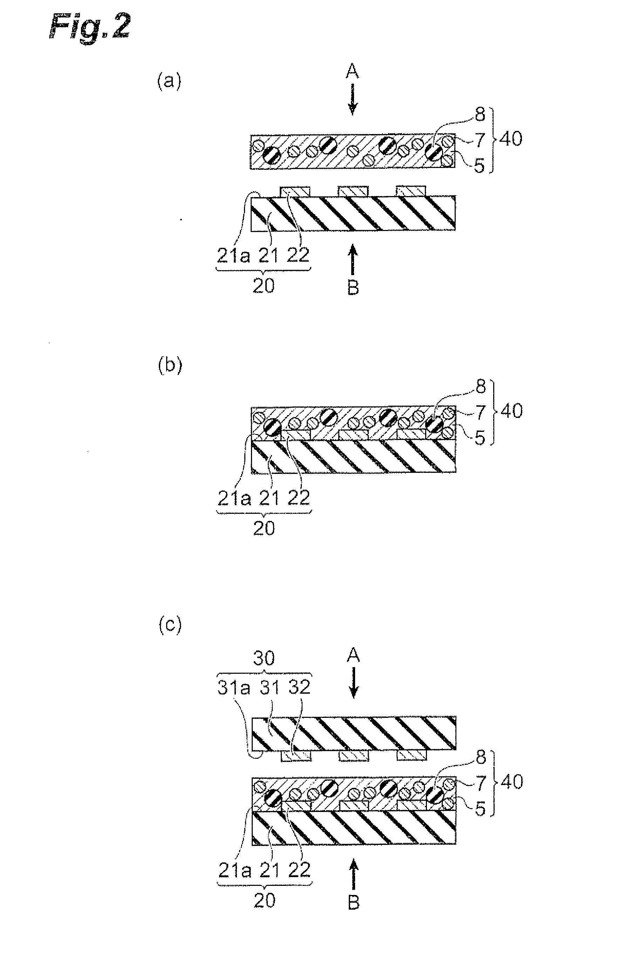

Fig. 2 is a process drawing in a simplified cross-sectional view showing an embodiment of a circuit member connection method according to the invention.

For this embodiment, there are first prepared the aforementioned first circuit member 20 and a circuit-connecting material 40 in the form of a film. The circuit-connecting material 40 is composed of an adhesive composition containing the conductive particles 7 and insulating particles 8.

The thickness of the circuit-connecting material 40 is preferably 5 to 50 µm. If the thickness of the circuit-connecting material 40 is less than 5 µm, the circuit-connecting material 40 may fail to sufficiently fill the area between the first and second circuit electrodes 22, 32. If the thickness of the circuit-connecting material 40 is greater than 50 µm, on the other hand, it may be difficult to ensure conduction between the first and second circuit electrodes 22, 32.

The circuit-connecting material 40 is then placed over the surface of the first circuit member 20 on which the circuit electrodes 22 have been formed. The circuit-connecting material 40 is pressed in the direction of the arrows A and B in Fig. 2(a) to provisionally join the circuit-connecting material 40 with the first circuit member 20 (see (Fig. 2(b)).

The pressure used in most cases for this procedure is preferred to be 0.1 to 30 MPa, although it is not particularly restricted so long as it is in a range that does not damage the circuit member. The pressure may be applied while heating, and the heating temperature should be a temperature that essentially does not cause hardening of the circuit- connecting material 40. The heating temperature is usually preferred to be 50 to 190°C. The heating and pressing are preferably carried out for a period in the range of 0.5 to 120 seconds.

In order to more effectively prevent deterioration of the circuit-connecting material 40 during the period from the provisional joining until the main joining described hereunder, the surface of the first circuit electrodes 22 is preferably composed of one or more metals selected from the group consisting of gold, silver, tin and platinum-family metals.

Next, as shown in Fig. 2(c), the second circuit member 30 is placed on the circuit-connecting material 40 with the second circuit electrodes 32 facing the first circuit member 20. When the circuit- connecting material 40 is formed on a support (not shown), the second circuit member 30 is placed on the circuit-connecting material film 40 after releasing the support. The entire circuit-connecting material 40 is pressed in the direction of the arrows A and B in Fig. 2(c) while heating. The heating temperature is a temperature that allows radicals to be generated by, for example, a free radical generator. This will cause the free radical generator to generate radicals to initiate polymerization of the radical polymerizing compound.

The heating temperature is, for example, 90 to 200^{o}C, and the connecting time is, for example, 1 second to 10 minutes. The conditions for the procedure may be appropriately selected according to the purpose of use, the adhesive composition and the circuit member, and postcuring may also be performed if necessary.

Heating of the circuit-connecting material 40 hardens the circuit-connecting material 40 with a sufficiently small distance between the first circuit electrodes 22 and second circuit electrodes 32, thus forming a strong joint (main joining) between the first circuit member 20 and second circuit member 30 via the circuit-connecting member 10.

Curing of the circuit-connecting material 40 completes formation of a circuit-connecting member 10, to obtain a circuit member connection structure 1 as shown in Fig. 1. The conditions for joining may be appropriately selected depending on the purpose of use, the adhesive composition and the circuit member.

According to this embodiment, the conductive particles 7 are able to contact both the opposing first and second circuit electrodes 22, 32 in the obtained connection structure 1, thus allowing connection resistance between the first and second circuit electrodes 22, 32 to be sufficiently reduced. Also, since the circuit-connecting member 10 comprises the cured circuit-connecting material composed of the adhesive composition that also contains the insulating particles 8, it is possible to adequately prevent shorting between the adjacent circuit electrodes 22 and between the circuit electrode 32.

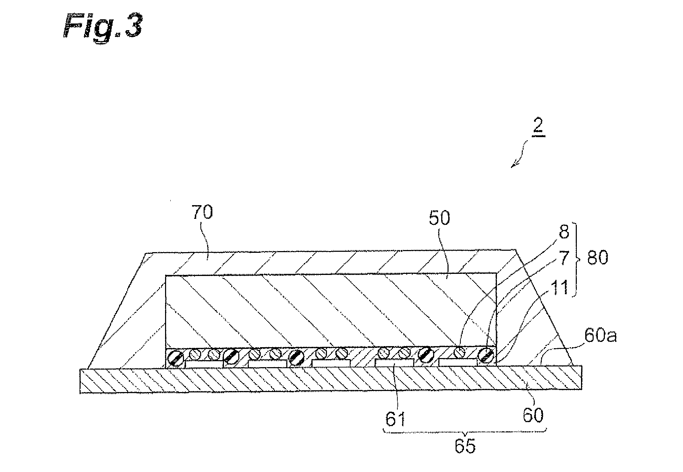

Fig. 3 is a simplified cross-sectional view showing an embodiment of a semiconductor device according to the invention. As shown in Fig. 3, the semiconductor device 2 of this embodiment comprises a semiconductor element 50 and a semiconductor element mounting board 65 with a board 60 composed of a semiconductor supporting member and with a circuit pattern 61 formed on the board 60. A semiconductor element connecting member 80 is provided between the semiconductor element 50 and semiconductor element mounting board 65 and forms an electrical connection between them. The semiconductor element connecting member 80 is laminated on the main surface 60a of the board 60, and the semiconductor element 50 is further laminated over the semiconductor element connecting member 80.

The board 60 is provided with a circuit pattern 61, and the circuit pattern 61 is electrically connected via the semiconductor connecting member 80 on the main surface 60a of the board 60, or directly with the semiconductor element 50. These are sealed with a sealing material 70 to form the semiconductor device 2.

The material for the semiconductor element 50 is not particularly restricted, and there may be used various types including Group 4 semiconductor elements such as silicon or germanium, Group III-V compound semiconductor elements such as GaAs, InP, GaP, InGaAs, InGaAsP, AlGaAs, InAs, GaInP, AlInP, AIGaInP, GaNAs, GaNP, GaInNAs, GaInNP, GaSb, InSb, GaN, AIN, InGaN or InNAsP, Group II-VI compound semiconductor elements such as HgTe, HgCdTe, CdMnTe, CdS, CdSe, MgSe, MgS, ZnSe or ZeTe, and CuInSe (CIS).

The semiconductor element connecting member 80 comprises an insulating layer 11 and conductive particles 7 and insulating particles 8 dispersed in the insulating layer 11. The 40°C elastic modulus of the semiconductor element connecting member 80 is preferably 100 to 3000 MPa and more preferably 500 to 2000 MPa.

The conductive particles 7 are situated not only between the semiconductor element 50 and circuit pattern 61, but also between the semiconductor element 50 and the main surface 60a. The insulating particles 8 are situated between the semiconductor element 50 and the main surface 60a.

In the semiconductor device 2 of this embodiment, the semiconductor element 50 and circuit pattern 61 are electrically connected via the conductive particles 7. Connection resistance between the semiconductor element 50 and circuit pattern 61 is therefore adequately reduced. Consequently, smooth current flow can be achieved between the semiconductor element 50 and circuit pattern 61, to allow the function of the semiconductor to be adequately exhibited. In addition, adding the conductive particles 7 in the proportion mentioned above can create more satisfactory electrical connection anisotropy. Sections may also be present where the semiconductor element 50 and circuit pattern 61 are in direct contact and are electrically connected.

The semiconductor element connecting member 80 is composed of the aforementioned cured adhesive composition containing conductive particles and insulating particles. Since this allows the insulating particles 8 to effectively inhibit aggregation of the conductive particles 7, electrical shorting between adjacent portions of the circuit pattern 61 or between adjacent terminals (not shown) of the semiconductor element 50 by the conductive particles 7 is sufficiently prevented.

In addition, because of the clear contrast between the conductive particles 7 and insulating particles 8 in the semiconductor device 2, it is possible to easily confirm whether or not shorting has occurred between adjacent portions of the circuit pattern 61 and between the terminals of the semiconductor element 50.

The embodiments described above are preferred embodiments of the invention, but the invention is not limited thereto. The invention may also be applied in a variety of other embodiments so long as the gist thereof is maintained.

### Examples

The present invention will now be explained in greater detail 15 through the following examples, with the understanding that these examples are in no way limitative on the invention.

### (Example 1)

### [Preparation of adhesive composition]

As radical polymerizing compounds there were prepared 10 parts by weight of urethane acrylate ("UA-5500T", trade name of Shin- Nakamura Chemical Co., Ltd.), 25 parts by weight of bis(acryloxyethyl)isocyanurate ("M-215", trade name of Toagosei Co., Ltd.), 10 parts by weight of dimethyloltricyclodecane diacrylate ("DCPA", trade name of Kyoeisha Chemical Co., Ltd.) and 1 part by weight of mono(2-methacryloyloxyethyl)acid phosphate ("P-2 M", trade name of Kyoeisha Chemical Co., Ltd.), and as a free radical generator there was prepared 4 parts by weight of a 50 wt% hydrocarbon-diluted solution of 2 ,5 -dimethyl-2,5 -bi s(2-ethylhexanoylperoxy)hexane (PERHEXA 250, trade name of NOF Corp.). There was also prepared 80 parts by weight of a 40 wt% solid content polyester-urethane resin solution obtained by dissolving a polyester-urethane resin ("UR8200", trade name of Toyobo, Ltd.) in a toluene/methyl ethyl ketone = 50/50 (weight ratio) mixed solvent. The radical polymerizing compounds and free radical generator were mixed with the polyester-urethane resin solution and the mixture was uniformly stirred to obtain an adhesive component.

A nickel layer was formed on the surface of polystyrene particles as nuclei to a thickness of 0.2 pm, and then a metal layer was formed on the outside of the nickel layer to a thickness of 0.04 [tm to produce conductive particles with a mean particle size of 4 pm. The 10% compression modulus (K value) of the conductive particles was measured to be 410 kgf/mm². Insulating particles with a mean particle size of 6 composed of a polystyrene-divinylbenzene copolymer, were also prepared. The 10% compression modulus (K value) of the insulating particles was measured to be 320 kgf/mm². The conductive particles were dispersed in the adhesive component at 3 parts by volume with respect to 100 parts by volume of the adhesive component. The insulating particles were also dispersed at 10 parts by weight with respect to 100 parts by weight of the adhesive component. An adhesive composition was obtained in this manner.

A coating apparatus was used to coat the obtained adhesive composition onto a PET film with a thickness of 75 µm which had been surface treated on one surface. The coated adhesive composition was heated with hot air at 70°C for 10 minutes to obtain an adhesive sheet (width: 15 cm, length: 60 m) comprising a laminate of the aforementioned PET film and an adhesive layer composed of an adhesive film with a thickness of 20 pm. The obtained adhesive sheet was cut to a width of 1.5 mm and wound up to 50 m on a plastic reel with an inner diameter of 40 mm and an outer diameter of 48 mm, with the adhesive layer surface facing the reel surface (thickness: 1.5 mm).

### [Fabrication of circuit member connection structure]

An adhesive sheet (width: 1.5 mm, length: 3 cm) obtained in the manner described above was placed on an ITO-coated glass board (15 C2/sq) that had been chamfered at the joint sections, in a manner with the board and adhesive layer in contact, to obtain a laminated body. The obtained laminated body was heated and pressed in the lamination direction for 2 seconds under conditions with a heating temperature of 70°C and a pressing force of 1 MPa, to bond the adhesive layer to the board. The PET film was then released from the adhesive layer.

Next, a flexible circuit board (FPC) was prepared by forming 600 tin-plated copper circuits (line width: 25 µm, pitch: 50 µm, thickness: 8 µm) as circuit electrodes on a polyimide film, and covering the area between the lines and portions of the lines with solder resist. The FPC was then placed over the adhesive layer in such a manner that the chamfered section of the board and the solder resist of the FPC were superimposed. These were then heated and pressed in the lamination direction for 1 second under conditions with a heating temperature of 24°C and a pressing force of 0.5 MPa, for provisional joining.

The laminated body comprising the provisionally joined board, adhesive layer and FPC was next set in a main contact bonding apparatus. A heat sealer was used for heating and pressing of the laminated body in the lamination direction for 5 seconds under conditions with a heating temperature of 180°C and a pressing force of 3 MPa, for main joining across the 1.5 mm width. A 150 pin-thick polytetrafluoroethylene cushion material was set on the surface of the FPC opposite the adhesive layer surface and used against the laminated body during this pressing. As a result, the cushion material exerted external pressure on the adhesive layer lying between the chamfered section of the joint of the board and the solder resist of the FPC. A circuit member connection structure was thus obtained.

### [Measurement of connection resistance]

The resistance between adjacent circuit electrodes of the FPC of the circuit member connection structure immediately after fabrication (initial connection resistance) was measured using a multimeter ("TR6845", trade name of Advantest Corp.). The resistance value was measured at 40 points between adjacent circuit electrodes, and the arithmetic mean of the resistance values was calculated. As a result, the initial connection resistance of the connection structure was 1.5 Q, indicating a satisfactory connection property.

### [Measurement of adhesive force]

The FPC of the circuit member connection structure immediately after fabrication was subjected to a 90° peeling test at a peel rate of 50 mm/min, and the maximum load at that time was measured as the adhesive force. As a result, the adhesive force was approximately 1000 N/m, indicating a satisfactory bonding property.

### [Evaluation of electrical shorting]

The PET film of the circuit member connection structure was released from the adhesive layer during fabrication. Next, a flexible circuit board (FPC) was prepared by forming 100 tin-plated copper circuits (line width: 25 pm, pitch: 50 pm, thickness: 8 µm) as circuit electrodes on a polyimide film, and covering the area between the lines and portions of the lines with solder resist. The FPC was then placed over the adhesive layer in such a manner that the chamfered section of the board and the solder resist of the FPC were superimposed. These were then heated and pressed in the lamination direction for 1 second under conditions with a heating temperature of 24°C and a pressing force of 0.5 MPa, for provisional joining.

The laminated body comprising the provisionally joined board, adhesive layer and FPC was next set in a main contact bonding apparatus. A heat sealer was used for heating and pressing of the laminated body in the lamination direction for 5 seconds under conditions with a heating temperature of 180°C and a pressing force of 3 MPa, for main joining across the 1.5 mm width. A 150 µm-thick polytetrafluoroethylene cushion material was set on the surface of the FPC opposite the adhesive layer surface and used against the laminated body during this pressing. As a result, the cushion material exerted external pressure on the adhesive layer lying between the chamfered section of the joint of the board and the solder resist of the FPC. A circuit member connection structure for evaluation of electrical shorting was thus obtained.

The circuit member connection structure immediately after fabrication was observed with a metallurgical microscope to evaluate the electrical shorting. Absence of electrical shorting was thus confirmed.

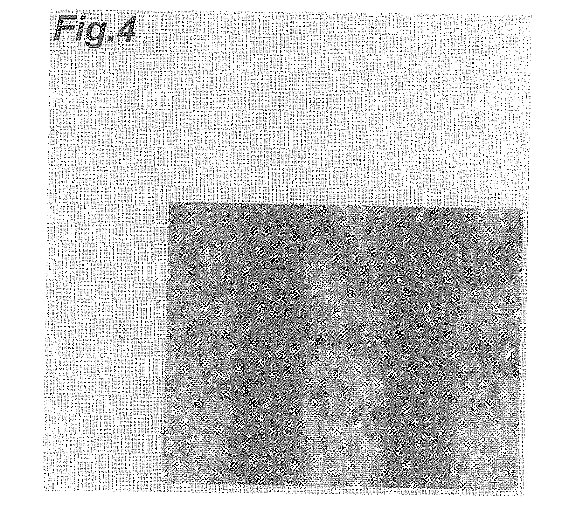

The circuit member connection structure as observed with a metallurgical microscope is shown in Fig. 4. The absence of electrical shorting can be clearly seen in Fig. 4.

### (Examples 2-10)

Circuit member connection structures were fabricated in the same manner as Example 1, except for using conductive particle mean sizes, conductive particle contents, insulating particle mean sizes and/or insulating particle contents as shown in Tables 1 and 2. Each of the obtained circuit member connection structures was used for measurement of the connection resistance and adhesive force and evaluation of electrical shorting, in the same manner as Example 1. The results are shown in Tables 1 and 2.

**[Table 1]**

| | Example | | | | | | |
|---|---|---|---|---|---|---|---|
| | 1 | 2 | 3 | 4 | 5 | 6 | 7 |
| Mean particle size of conductive particles Rc µm | 4 | 4 | 4 | 4 | 3 | 3 | 3 |
| Conductive particle content (parts by vol.) | 3 | 3 | 3 | 3 | 5 | 5 | 10 |
| Mean particle size of insulating particles Ri (µm) | 6 | 6 | 6 | 10 | 9 | 6 | 6 |
| Insulating particle content (parts by wt.) | 10 | 5 | 15 | 10 | 5 | 10 | 5 |
| Ri/Rc (%) | 150 | 150 | 150 | 250 | 300 | 200 | 200 |
| Connection resistance (Ω) | 1.5 | 1.3 | 1.6 | 1.5 | 1.5 5 | 1.3 | 1.6 |
| Adhesive force (N/m) | 1000 | 1100 | 900 | 1000 | 1000 | 1100 | 900 |
| Electrical shorting | - | - | - | - | - | - | - |

**[Table 2]**

| | Example | | | | | |
|---|---|---|---|---|---|---|
| | 8 | 9 | 10 | 11 | 12 | 13 |
| Mean particle size of conductive particles Rc (µm) | 5 | 5 | 5 | 5 | 5 | 4 |
| Conductive particle content (parts by vol.) | 3 | 3 | 5 | 5 | 5 | 3 |
| Mean particle size of insulating particles Ri (µm) | 6 | 12 | 12 2 | 12 | 12 | 6 |
| Insulating particle content (parts by wt.) | 5 | 10 | 5 | 5 | 5 | 10 |
| Ri/Rc (%) | 120 | 240 | 240 | 240 | 240 | 150 |
| Connection resistance (Ω) | 1.5 | 1.5 | 1.3 | 1.6 | 1.7 | 1.4 |
| Adhesive force (N/m) | 1000 | 1000 | 1100 | 1200 | 800 | 1000 |
| Electrical shorting | - | - | - | - | - | - |

### (Example 11)

A circuit member connection structure was fabricated in the same manner as Example 10, except for using an urethane acrylate content of 35 parts by weight instead of 10 parts by weight and a bis(acryloxyethyl)isocyanurate content of 0 parts by weight instead of 25 parts by weight (i.e., no addition of bis(acryloxyethyl)isocyanurate). Each of the obtained circuit member connection structures was used for measurement of the connection resistance and adhesive force and evaluation of electrical shorting, in the same manner as Example 1. The results are shown in Table 2.

### (Example 12)

A circuit member connection structure was fabricated in the same manner as Example 10, except for using a phenoxy resin (molecular weight: 45,000) instead of the polyester-urethane resin. Each of the obtained circuit member connection structures was used for measurement of the connection resistance and adhesive force and evaluation of electrical shorting, in the same manner as Example 1. The results are shown in Table 2.

### (Example 13)

A circuit member connection structure was fabricated in the same manner as Example 1, except that the insulating particles were composed of a silicone resin instead of a polystyrene-divinylbenzene copolymer. The 10% compression modulus (K value) of the insulating particles was measured to be 30 kgf/mm², Each of the obtained circuit member connection structures was used for measurement of the connection resistance and adhesive force and evaluation of electrical shorting, in the same manner as Example 1. The results are shown in Table 2.

### (Comparative Example 1)

A circuit member connection structure was fabricated in the same manner as Example 1, except that no insulating particles were used. Each of the obtained circuit member connection structures was used for measurement of the connection resistance and adhesive force and evaluation of electrical shorting, in the same manner as Example 1. The results are shown in Table 3.

**[Table 3]**

| | Comp. Ex. | | | | | | |
|---|---|---|---|---|---|---|---|
| | 1 | 2 | 3 | 4 | 5 | 6 | 7 |
| Mean particle size of conductive particles Rc (µm) | 4 | 4 | 4 | 3 | 3 | 5 | 5 |
| Conductive particle content (pans by vol.) | 3 | 3 | 3 | 5 | 5 | 5 | 5 |
| Mean particle size of insulating particles Ri (µm) | --- | 3 | 3 | 10 | 3 | 5 | 20 |
| Insulating particle content parts by wt.) | --- | 10 | 30 | 5 | 5 | 5 | 5 |
| Ri/Rc (%) | --- | 75 | 75 | 333 | 100 | 100 | 400 |
| Connection resistance (Ω) | 1.5 | 1.3 | 19 | 1.6 | 1.5 | 1.5 | 5.5 |
| Adhesive force (N/m) | 1000 | 1050 | 820 | 1000 | 1000 | 1000 | 1100 |
| Electrical shorting | + | + | - | + | + | - | + |

### (Comparative Examples 2-7)

Circuit member connection structures were fabricated in the same manner as Example 1, except for using conductive particle mean sizes, conductive particle contents, insulating particle mean sizes and/or insulating particle contents as shown in Table 3. Each of the obtained circuit member connection structures was used for measurement of the connection resistance and adhesive force and evaluation of electrical shorting, in the same manner as Example 1. The results are shown in Table 3.

### Industrial Applicability

According to the invention it is possible to provide an adhesive composition that is suitable for COF and fine pitches, and that sufficiently prevents aggregation of conductive particles at the joint edges of LCD panels, thus allowing electrical shorting between adjacent electrodes to be adequately prevented and providing excellent connection reliability compared to adhesive compositions in conventional circuit-connecting adhesive films.

An adhesive composition comprising an adhesive component, conductive particles and insulating particles, wherein the ratio of the mean particle size of the insulating particles Ri to the mean particle size of the conductive particles Rc (Ri/Rc) is 120 to 300%.

An adhesive composition which comprises the insulating particles at 1 to 20 parts by weight with respect to 100 parts by weight of the adhesive component.

A circuit-connecting material that comprises an adhesive composition and is used to bond the circuit electrode- bearing circuit members together in such a manner that the circuit electrodes of the circuit members are electrically connected.

A circuit-connecting material which is formed into a film.

A circuit member connection structure comprising:
a first circuit member having a first circuit electrode formed on a main surface of a first circuit board;
a second circuit member having a second circuit electrode formed on a main surface of a second circuit board; and
a circuit-connecting member formed between the main surface of the first circuit board and the main surface of the second circuit board, the circuit-connecting member electrically connecting the first circuit electrode and second circuit electrode as they are positioned facing each other,
wherein the circuit-connecting member is the cured product of a circuit-connecting material.

A semiconductor device comprising:
a semiconductor element;
a board on which the semiconductor element is mounted; and a semiconductor element connecting member provided between the semiconductor element and the board, the semiconductor element connecting member electrically connecting the semiconductor element and the board,
wherein the semiconductor element connecting member is the cured product of an adhesive composition.

## Claims

1. An adhesive composition comprising an adhesive component, conductive particles and insulating particles,
wherein the ratio of the mean particle size of the insulating particles Ri to the mean particle size of the conductive particles Rc (Ri/Rc) is 120 to 300%,
the adhesive composition comprises the insulating particles at 50 to 200 parts by volume with respect to 100 parts by volume of the conductive particles.

2. An adhesive composition according to claim 1, which comprises the insulating particles at 1 to 20 parts by weight with respect to 100 parts by weight of the adhesive component.

3. An adhesive composition according to claim 1 or 2, wherein the insulating particles are particles composed mainly of an insulating resin.

4. An adhesive composition according to claim 3, wherein the insulating resin is a silicone resin.

5. An adhesive composition according to any one of claim 1 to 4, wherein the mean particle size of the conductive particles Rc is 1 to 20 µm,

6. An adhesive composition according to claim 5, wherein the mean particle size of the conductive particles Rc is 2 to 10 µm.

7. An adhesive composition according to any one of claims 1 to 6, wherein the mean particle size of the insulating particles Ri is 1.2 to 20 µm.

8. An adhesive composition according to any one of claims 1 to 7, wherein the ratio of the mean particle size of the insulating particles Ri to the mean particle size of the conductive particles Rc (Ri/Rc) is 130 to 200%.

9. An adhesive composition according to any one of claims 1 to 8, which comprises the conductive particles at 0.1 to 30 parts by volume with respect to 1.D0 parts by volume of the adhesive component.

10. An adhesive composition according to any one of claims 1 to 9, wherein the insulating particles have a 10% compression modulus (K value) of no greater than the K value of the conductive particles.

11. An adhesive composition according to claim 10, wherein the K value of the conductive particles is 100 to 1000 kgf/mm² and the K value of the insulating particles is 1 to 1000 kgf/mm².

12. An adhesive composition according to claim 1, which comprises the insulating particles at 0.1 to 20 parts by weight with respect to 100 parts by weight of the adhesive component.

13. A circuit-connecting material that comprises an adhesive composition according to any one of claims 1 to 12 and is used to bond the circuit electrode-bearing circuit members together in such a manner that the circuit electrodes of the circuit members are electrically connected.

14. A circuit-connecting material according to claim 13, which is formed into a film.

15. A circuit member connection structure comprising:
a first circuit member having a first circuit electrode formed on a main surface of a first circuit board;
a second circuit member having a second circuit electrode formed on a main surface of a second circuit board; and
a circuit-connecting member formed between the main surface of the first circuit board and the main surface of the second circuit board, the circuit-connecting member electrically connecting the first circuit electrode and second circuit electrode as they are positioned facing each other,
wherein the circuit-connecting member is the cured product of a circuit-connecting material according to claim 13 or 14.

16. A semiconductor device comprising:
a semiconductor element;
a board on which the semiconductor element is mounted; and
a semiconductor element connecting member provided between the semiconductor element and the board, the semiconductor element connecting member electrically connecting the semiconductor element and the board,
wherein the semiconductor element connecting member is the cured product of an adhesive composition according to any one of claims 1 to 12.
